# EUROPÄISCHE PATENTANMELDUNG

(11) **EP 1 744 611 A2**
(43) Veröffentlichungstag der Anmeldung: **17.01.2007**
(21) Anmeldenummer: 06013712.2
(22) Anmeldetag: 03.07.2006
(51) Int. Cl.: H05K 7/20

(54) **Kühlvorrichtung, insbesondere für ein elektronisches Steuergerät**

(30) Priorität: 12.07.2005 DE 102005032814
(71) Anmelder: Behr GmbH & Co. KG, 70469 Stuttgart (DE)
(72) Erfinder: Damsohn, Herbert, Dr.-Ing., 73773 Aichwald (DE); Isermeyer, Tobias, 70736 Fellbach (DE); Pfender, Conrad, Dr.-Ing., 74354 Besigheim (DE); Staffa, Karl-Heinz, Dipl-Ing., 70567 Stuttgart (DE)
(74) Vertreter: Mantel, Berthold Friedrich

(57) **Zusammenfassung**

Die Erfindung betrifft eine Kühlvorrichtung (2), insbesondere für ein elektronisches Steuergerät (1), mit einem von einem kühl- oder kältemitteldurchströmbaren Bereich und einem Wärmeübergangsbereich, die U-förmig mit einem mittleren Bereich und zwei schenkelartigen Bereichen ausgebildet ist.

## Beschreibung

Die Erfindung betrifft eine Kühlvorrichtung, insbesondere für ein elektronisches Steuergerät für ein Kraftfahrzeug, gemäß dem Oberbegriff des Anspruches 1.

Aus der DE 103 16 449 A1 ist ein elektronisches Steuergerät mit integrierter Kühlung bekannt, das insbesondere für den Automotivbereich vorgesehen ist. Es besteht zur Abführung hoher anfallender Wärme aus einem Schaltungsträger mit elektrischen Leistungsbauelementen, einem Bauelementeträger mit elektrischen Bauelementen und bedrahteten Sonderbauelementen, wie Elektrolytkondensatoren und Spulen, und aus einem flüssigkeitsdurchströmten Kühlkörper zur Wärmeabführung. Der Kühlkörper weist ein plattenförmiges Gehäuse mit Kanalabschnitten für eine durchströmende Kühlflüssigkeit auf und ist zwischen dem Schaltungsträger und dem Bauelementeträger angeordnet, so dass der flüssigkeitsdurchströmte. Kühlkörper in das elektronische Steuergerät integriert ist. Hierbei treten jedoch Probleme bei der Abdichtung der einzelnen Platten auf.

Die EP 0 968 885 A2 offenbart eine Kühlplatte für eine elektronische Motorsteuereinheit. Die Kühlplatte weist ein Gehäuse mit einer ebenen Frontfläche auf, auf welche die Steuereinheit montiert werden kann, die mit einer zentralen Aufnahme für Komponenten versehen ist, die von der Rückseite der Steuereinheit überstehen. Das Gehäuse umfasst auch Strömungskanäle. Diese können in einem Gussteil ausgebildet sein, wobei sie die Aufnahme an drei Seiten umgeben. Auf dem Gussteil ist eine Abdeckplatte angebracht, um die Kanäle zu verschließen. Die Steuereinheit hat üblicherweise eine Rückwand aus Metall, jedoch kann die Steuereinheit auch direkt an der Kühlplatte angebracht sein, d.h, die Kühlplatte kann integriert in die Steuereinheit ausgebildet sein.

Eine derartige Kühlvorrichung lässt noch Wünsche offen.

Es ist Aufgabe der Erfindung, eine verbesserte Kühlvorrichtung zur Verfügung zu stellen. Diese Aufgabe wird gelöst durch eine Kühlvorrichtung mit den Merkmalen des Anspruchs 1. Vorteilhafte Ausgestaltungen sind Gegenstand der Unteransprüche.

Erfindungsgemäß ist eine Kühlvorrichtung vorgesehen, insbesondere für ein elektronisches Steuergerät, mit einem von einem kühl- oder kältemitteldurchströmbaren Bereich und einem Wärmeübergangsbereich, die U-förmig mit einem mittleren Bereich und zwei schenkelartigen Bereichen ausgebildet ist. An der Kühlvorrichtung ist hierbei ein entsprechend ausgebildetes Steuergerät, insbesondere ein Motorsteuergerät, bevorzugt aus einfache Weise wieder lösbar anbringbar. Hierfür sind Steuergerät und Kühlvorrichtung getrennt voneinander ausgebildet. Aneinander lösbar fixiert werden sie bevorzugt mittels Haltevorrichtungen, Schrauben; Clipsverbindungen, Riegeln o.ä.

Die Kühlvorrichtung weist bevorzugt als Kernelement ein kühl- oder kältemitteldurchströmbares Flachrohr auf, welches den kühl- oder kältemitteldurchströmbaren Bereich bildet. Dabei kann das Flachrohr bspw. ein Mehrkammerflachrohr sein, jedoch können auch Turbulenzeinlagen o.ä. eingebracht sein. Im Falle dass das Kühl- oder Kältemittel das Flachrohr unter einem hohen Druck durchströmt, kann das Flachrohr druckfest ausgebildet sein.

Das Flachrohr ist bevorzugt im Wesentlichen U-förmig ausgebildet. Dies ermöglicht eine einfache Herstellung, insbesondere mittels Biegen, und ein zur Verfügung stellen der Kälteleistung - bei entsprechender Anordnung der besonders hitzeempfindlichen oder wärmeerzeugenden Bauteile des an der Kühlvorrichtung angebrachten Steuergeräts - in den relevanten Bereichen.

Bevorzugt weist das Flachrohr mindestens eine Anlagefläche auf, an welcher ein Steuergerät direkt oder indirekt - bspw. wenn eine zusätzliche Wand dazwischen angeordnet ist - flächig, bevorzugt großflächig, anliegen kann. Dies ermöglicht einen guten Wärmeübergang. Bevorzugt sind mindestens zwei entsprechende Anlageflächen vorgesehen, wobei diese nicht notwendigerweise über die gesamte Länge des Flachrohres vorgesehen sein müssen, sondern ggf. auch unterbrochen sein können, bspw. im mittleren Bereich, so dass zwei Anlageflächen nur in den beiden Schenkelbereichen vorgesehen sind, im mittleren Bereich jedoch nur eine.

Der Wärmeübergangsbereich wird bevorzugt durch mindestens ein, vorzugsweise zwei oder ggf. auch mehr Wärmeübertragungselemente gebildet. Dabei ist das Wärmeübertragungselement vorzugsweise Teil der Anlagefläche und erstreckt sich über die Abmessungen des Flachrohres hinaus.

Das Wärmeübertragungselement liegt bevorzugt an zwei benachbarten Seiten des Flachrohrs flächig an oder ist einstückig mit demselben ausgebildet, bspw. durch Extrudieren eines entsprechend profilierten Flachrohres. Alternativ kann das Wärmeübertragungselement auch am Flachrohr angelötet sein.

Bevorzugt ist das Wärmeübertragungselement Z-förmig ausgebildet, wobei jeweils zwei benachbarte Ebenen senkrecht zueinander angeordnet sind. Dabei liegt das Flachrohr an zwei der Ebenen an, wobei die mittlere Ebene etwa der Breitseite des Flachrohres (Höhe, Schenkellänge) entsprechende Abmessungen aufweist. Die andere Ebene ragt seitlich nach außen über die Schmalseite des Flachrohres hinaus. Die dritte Ebene ragt in die entgegengesetzte Richtung.

Das Wärmeübertragungselement weist bevorzugt mindestens einen Vorsprung für die Positionierung und Vorfixierung desselben am Flachrohr auf, bevorzugt jedoch mehrere. Diese sind etwa entsprechend der Breite der Schmalseite des Flachrohres beabstandet von der mittleren Ebene angeordnet. Die Vorsprünge vereinfachen die Montage und Fixierung des Wärmeübertragungselements am Flachrohr vor dem Löten.

Das Wärmeübertragungselement kann eine Prägung für die Positionierung des Anschlussrohres aufweisen. Diese erleichtert die Positionierung und Vorfixierung des Wärmeübertragungselements am Flachrohr und zugehörigen Anschlussrohr. Zudem stellt eine Prägung die Dichtheit des Anschlussrohres an dessen zu verschließenden Ende sicher.

Bevorzugt ist an der Kühlvorrichtung ein Teil einer Haltevorrichtung für das Steuergerät vorgesehen. Dieser Teil wird vorzugsweise durch Öffnungen, insbesondere durch Bohrungen gebildet, durch welche bspw. ein Schraubkopf oder ein anderes Element mit Hinterschnitt ragen kann. Die Sicherung der Position des Steuergeräts an der Kühlvorrichtung wird bevorzugt durch einander entsprechende Abmessungen unterstützt, wobei großflächige Anlagen vorgesehen sind. Diese sind in erster Linie jedoch in Hinblick auf einen guten Wärmeübergang wichtig.

Die Haltevorrichtung wird vorzugsweise durch mindestens ein mit einem Kopf versehenen, vorstehenden Bereich am Steuergerät, eine Öffnung in der Kühlvorrichtung, durch welche der Kopf am Steuergerät ragt, und mindestens ein mit einer Öffnung versehenes Federelement gebildet, das auf den am Steuergerät ausgebildeten Kopf aufgesetzt und gegen denselben verspannt ist. Diese Ausgestaltung ist relativ einfach ausgebildet, wobei das Steuergerät einfach an der Kühlvorrichtung anbringbar und wieder lösbar ist. Durch die federnde Vorspannung der Federelemente, insbesondere Federklammern, ist ein sicherer Kontakt gewährleistet. Relativbewegungen können im Wesentlichen ausgeschlossen werden, so dass es nicht zu Geräuschen kommt, jedoch sind Relativbewegungen zueinander in Folge unterschiedlicher Wärmeausdehnungen in ausreichendem Umfang möglich, so dass es nicht zu Spannungen kommt.

Im Folgenden wird die Erfindung anhand dreier Ausführungsbeispiele, teilweise unter Bezugnahme auf die Zeichnung, näher erläutert. In der Zeichnung zeigen:
- Fig. 1: eine perspektivische Darstellung einer Kühlvorrichtung mit Steuergerät gemäß dem ersten Ausführungsbeispiel,
- Fig. 2: eine perspektivische Darstellung der Kühlvorrichtung von Fig. 1,
- Fig. 3: eine perspektivische Darstellung einer Rippenfläche der Kühlvorrichtung von Fig.1,

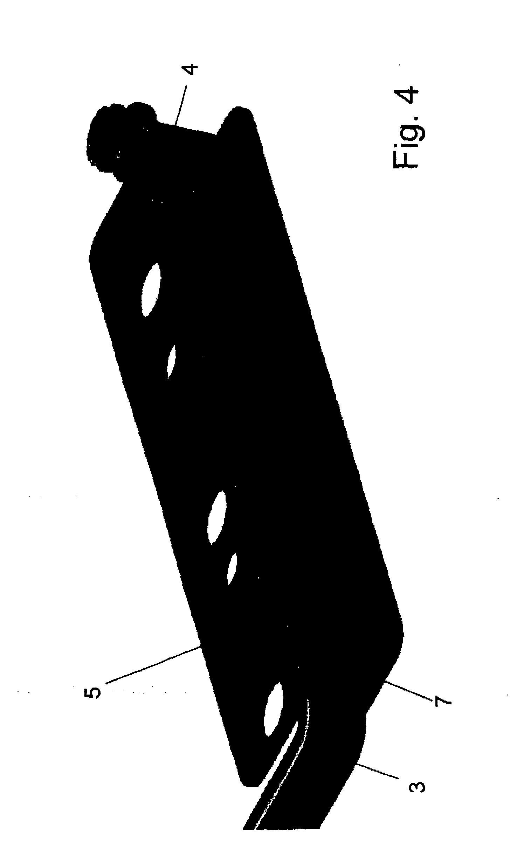

- Fig. 4: eine perspektivische Darstellung eines Teils der Kühlvorrichtung von Fig. 1 ohne Haltevorrichtung,
- Fig. 5: eine perspektivische Detailansicht der Haltevorrichtung für das Steuergerät von Fig. 1,
- Fig. 6: eine perspektivische Darstellung einer Kühlvorrichtung gemäß dem dritten Ausführungsbeispiel, und
- Fig. 7: eine perspektivische Detailansicht der Haltevorrichtung der Kühlvorrichtung von Fig. 6.

Gemäß dem ersten Ausführungsbeispiel ist zur Kühlung eines elektronischen Motorsteuergeräts, im Folgenden als Steuergerät 1 bezeichnet, für einen Kraftfahrzeugmotor eine Kühlvorrichtung 2 vorgesehen. Das Steuergerät 1 ist einfach lösbar an der Kühlvorrichtung 2 angebracht, wobei Steuergerät 1 und Kühlvorrichtung 2 getrennte Bauteile sind. Hierbei sind beide im Prinzip unabhängig voneinander betätigbar.

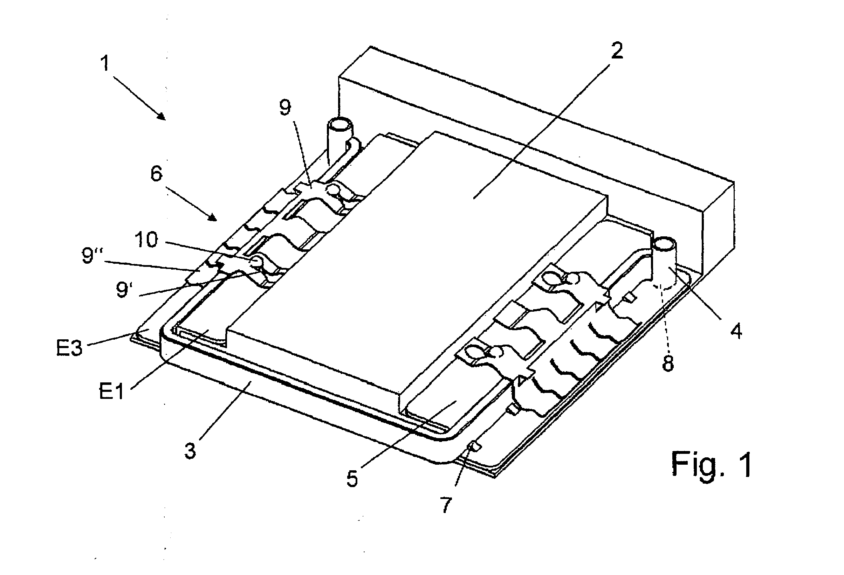

Die Kühlvorrichtung 2 ist U-förmig oder bügelartig ausgebildet, wobei Kern der Kühlvorrichtung 2 ein U-förmig gebogenes Flachrohr 3 ist. Beim Flachrohr 3 handelt es sich um ein zur Vereinfachung des Lötvorgangs lotplatiertes Bauteil, das entsprechend Fig. 1 gebogen ist, d.h. es weist zwei etwa gleich lange Schenkel und ein entsprechend langes Mittelstück sowie zwei nach außen gebogene kurze Enden auf, wobei das Flachrohr 3 durchaus auch in eine andere Richtung gebogen oder nicht gebogen sein kann. Das Flachrohr 3 ragt mit seinen beiden Enden zur Kühl-/Kältemittelein- und - ausleitung in auf einer Seite endseitig verschlossene Rundrohre 4, welche seitlich je eine geschlitzte Öffnung aufweisen. Für die Herstellung wird das Rundrohr 4 angeschlitzt, so dass das Flachrohr 3 mit seinem entsprechenden Ende bei geringen Spaltgrößen eingebracht werden kann. Im anschließenden Lötprozess wird der verbleibende Spalt dicht verschlossen. Am anderen Ende der Rundrohre 4 kann die Basis für eine Schnellkupplung (vgl.

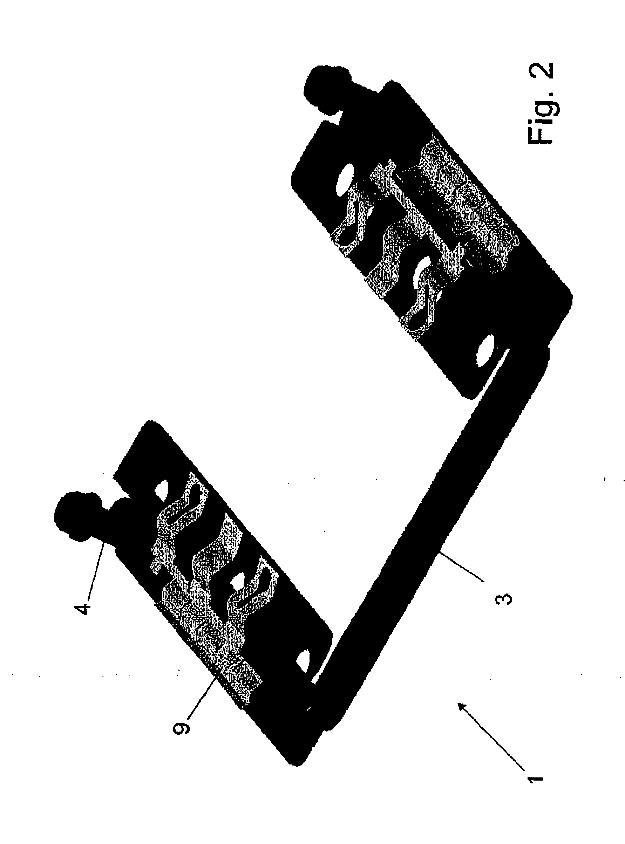

Fig. 2) oder eine Schraubverbindung für den Anschluss zum kühlenden Niedertemperatur-Kreislauf vorgesehen sein.

Auf der Unterseite des Flachrohres 3 ist im Bereich jedes Schenkels gemäß dem vorliegenden Ausführungsbeispiel ein als Stanzbiegeteil ausgebildetes, vorliegend aus Aluminium gefertigtes Wärmeübertragungselement 5 angelötet, welches der Vergrößerung der Kontaktflächen zwischen Steuergerät 1 und Flachrohr 3 dienen.

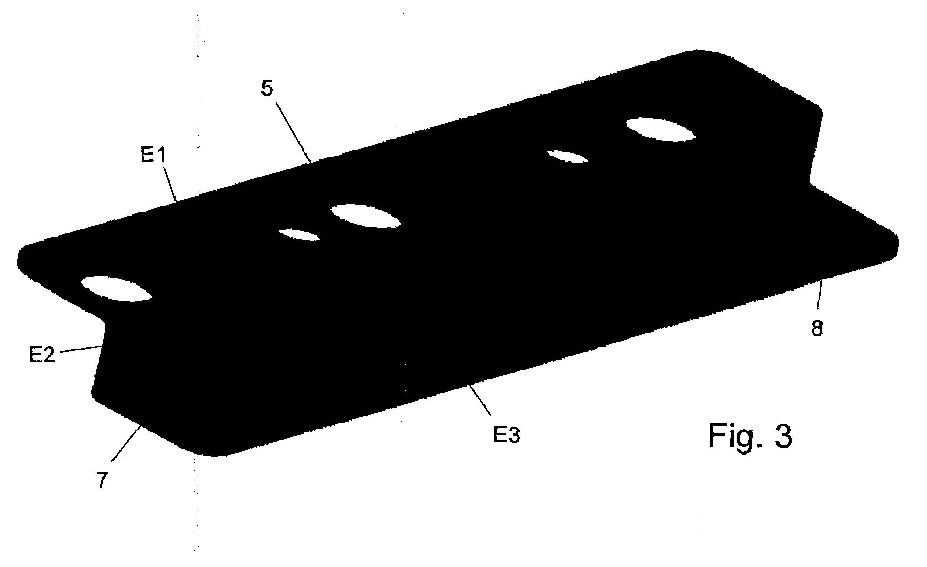

Die Wärmeübertragungselemente 5 sind, wie aus Fig. 3 ersichtlich, Z-förmig ausgebildet, wobei die benachbarten Ebenen E1 und E2 bzw. E2 und E3 eines Wärmeübertragungselements 5 jeweils in einem rechten Winkel zueinander angeordnet sind. In der ersten Ebene E1 jedes Wärmeübertragungselements 5 sind Öffnungen für am Steuergerät 1 vorgesehene Schraubdome und für Köpfe, bspw. gebildet durch Schrauben, die Teil einer an späterer Stelle näher beschriebenen Haltevorrichtung 6 sind, vorgesehen. Die zweite Ebene E2 jedes Wärmeübertragungselements 5 ist eben ausgebildet und parallel zur breiteren Fläche des Flachrohres 3 und mit einer Fläche in direkter Anlage an dasselbe angeordnet. Die dritte Ebene E3 jedes Wärmeübertragungselements 5 weist eingestanzte Vorsprünge 7 für die Schmalseite de Flachrohres 3 und eine Prägung 8 für das Ende der Rundrohre 4 auf. Dabei dienen die Vorsprünge 7 als Vorfixierungen für die Positionierung des Flachrohres 3 bei der Vormontage vor dem Verlöten desselben mit dem entsprechenden Wärmeübertragungselement 5. Vorliegend sind die Vorsprünge 7 keilförmig ausgebildet, wobei das spitze Ende weg vom Flachrohr 3 zeigt. Die Prägung 8 dient entsprechend der Fixierung des entsprechenden Rundrohres 4 für den Lötprozess.

Das Flachrohr 3 liegt mit zwei benachbarten Seiten an den Ebenen E2 und E3 des Wärmeübertragungselements 5 an, d.h. es ist eine große Kontaktfläche von Flachrohr 3 und Wärmeübertragungselement 5 gegeben. In Folge des Anlötens ist ein guter Wärmeübergang zwischen den beiden Bauteilen gewährleistet. Vorliegend erfolgt das Verlöten von Flachrohr 3, Rundrohren 4 und Wärmeübertragungselementen 5 in einem Arbeitsgang, wobei gleichzeitig ein Dichtlöten der Verbindungen von Flachrohr 3 und Rundrohren 4 erfolgt.

Das Wärmeübertragungselement 5 liegt auf der dem Flachrohr 3 abgewandten Seite vorliegend mit den Ebenen E1 und E3 an den beiden Platinen und mit der Ebene E2 an einem Gehäusebereich des Steuergeräts 1 an, so dass auf Grund des großflächigen Kontakts eine gute Kühlleistung möglich ist.

Gemäß dem vorliegenden ersten Ausführungsbeispiel ist keine vollsymmetrische Ausgestaltung der beiden Wärmeübertragungselemente 5 auf Grund der Anordnung der Schraubdome am Steuergerät 1 möglich, weshalb die beiden Wärmeübertragungselemente 5 vorliegend spiegelsymmetrisch ausgebildet sind. Falls möglich, wäre jedoch eine vollsymmetrische Ausgestaltung zu bevorzugen.

Die Haltevorrichtung 6, d.h. die Vorrichtung, welche das Steuergerät 1 an der Kühlvorrichtung 2 lösbar fixiert, wird gemäß dem vorliegenden ersten Ausführungsbeispiel durch zwei gebogene, mehrarmige Federklammern 9 in Verbindung mit vier am Steuergerät 1 ausgebildeten Köpfen 10 und vier Öffnungen im Wärmeübertragungselement 5 gebildet. Jede Federklammer 9 weist vorliegend drei an der Ebene E1 federnd anliegende Arme 9' und fünf federnd an der Ebene E3 anliegende Arme 9" auf (vgl. Fig. 1). Im mittleren Bereich liegt die Federklammer 9 an oder dicht benachbart zum Flachrohr 3. In den äußeren der drei Arme 9', die an der Ebene E1 anliegen, sind die Öffnungen für die Köpfe 10 vorgesehen, durch welche die Köpfe 10 des Steuergeräts 1 ragen. Dabei sind die Öffnungen in den Federklammern 9 derart ausgebildet, dass sie einen kreisförmigen Bereich für die Durchführung des entsprechenden Kopfes 10 und einen schlitzartigen Bereich, der enger als der Kopfdurchmesser ist, für die Fixierung unter Vorspannung aufweisen. Im Bereich des kreisförmigen Bereichs liegt der Arm 9' an der Ebene E1 an, im Bereich mit dem Schlitz ist der Arm 9' jedoch beabstandet von der Ebene E1 ausgebildet und liegt auf der Unterseite des Kopfes 10 an. Die an der Ebene E3 anliegenden Arme 9" , wie auch das äußere Ende der Arme 9', dienen der Aufbringung einer Gegenkraft, damit das Steuergerät 1 in Anlage an die Ebenen E1 und E3 gezogen wird. Wird das Steuergerät 1 an der Kühlvorrichtung 2 positioniert, so werden die beiden Federklammern 9 aufgesetzt und unter elastischer Verformung unter die Köpfe 10 geschoben, so dass eine sichere, einfach lösbare Verbindung von Steuergerät 1 und Kühlvorrichtung 2 entsteht.

Durch das Vorsehen der zuvor beschriebenen Haltevorrichtung 6 ist eine einfache Demontage des gesamten Steuergeräts 1 möglich, ohne dass Arbeiten an der Kühlvorrichtung 2 erforderlich sind.

Das Steuergerät 1 ist vorliegend mit zwei Platinen ausgebildet, welche übereinander angeordnet sind, wobei sie unterschiedliche Abmessungen aufweisen, so dass sich für das Steuergerät 1 eine gestufte Gestalt ergibt (siehe Fig. 1). Die gestufte Gestalt bietet zudem Vorteile in Hinblick auf die sichere Anbringung des Steuergeräts 1 an der Kühlvorrichtung 2.

Auf beiden Platinen des Steuergeräts 1 ist die wärmeerzeugende Leistungselektronik möglichst außenseitig angeordnet, so dass sie möglichst nahe am Flachrohr 3 der Kühlvorrichtung 2 angeordnet sind, wodurch eine relativ kurze Wärmeübertragungsstrecke realisiert werden kann.

Gemäß einem nicht in der Zeichnung dargestellten zweiten Ausführungsbeispiel ist das Flachrohr samt Rippenflächen extrudiert einstückig ausgebildet, so dass das Anlöten der Rippenflächen, wie beim ersten Ausführungsbeispiel erforderlich, entfallen kann. Bei der Herstellung muss lediglich vor dem Biegen des "U" ein Teil der Rippenflächen entfernt werden, nämlich im mittleren Bereich und an den Endbereichen, in welchen der Übergang zu den Rundrohren vorgesehen ist. Dadurch ergibt sich eine Ausgestaltung, die im Wesentlichen entsprechend der des ersten Ausführungsbeispiels entspricht.

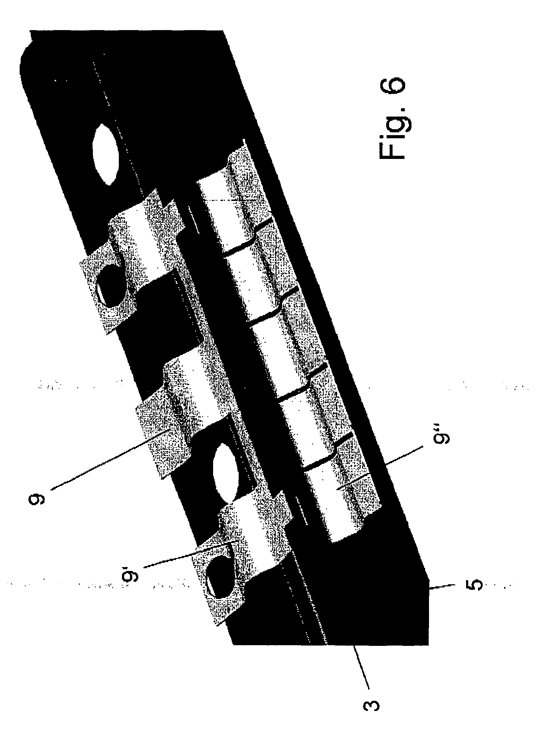

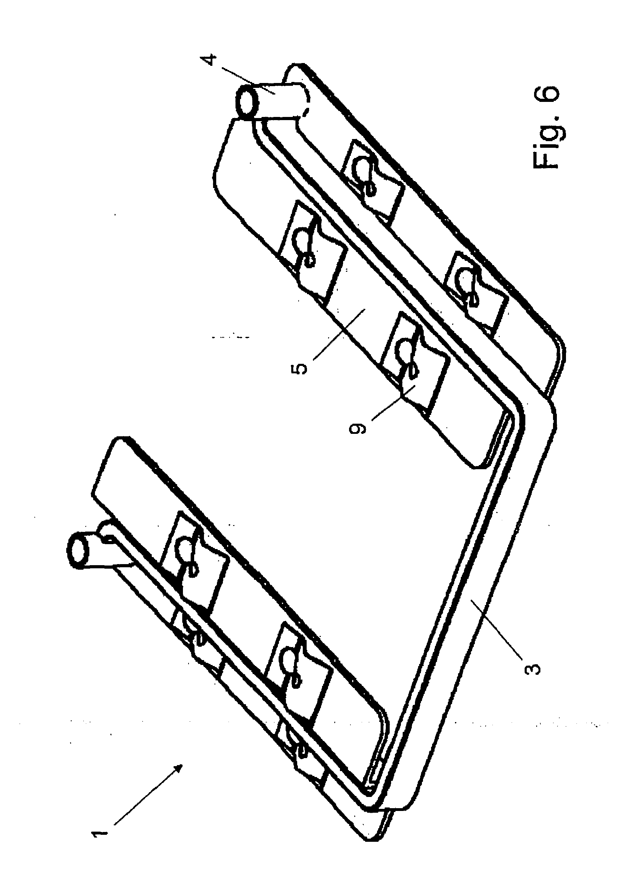

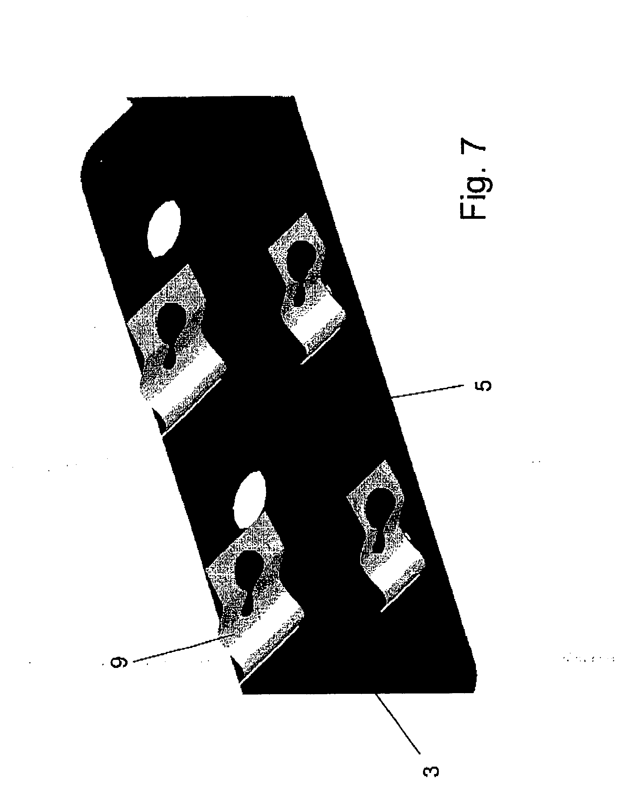

Gemäß dem dritten, in Figuren 6 und 7 dargestellten Ausführungsbeispiel sind acht Federklammern 9 vorgesehen, die in seitlicher Richtung aufgeschoben werden. Die Montagebewegung der Federklammern 9 ist in Fig. 7 durch einen Pfeil dargestellt. Ferner sind auf beiden Platinenebenen Köpfe (nicht dargestellt) vorgesehen, mit denen die Federklammern 9 zusammenwirken. Ansonsten stimmt das dritte Ausführungsbeispiel mit dem ersten Ausführungsbeispiel überein, so dass nicht näher hierauf eingegangen wird.

Die als Ausführungsbeispiele beschriebenen Kühlvorrichtungen können beispielsweise in einem Niedertemperatur-Kühlmittelkreislauf oder einem Teilstrom des Kältemittelkreislaufs der Klimaanlage, wobei der Teilstrom vorteilhafterweise am Kältemittelkondensator entnommen und am Kältemittelsammler wieder dem Reststrom zugeführt wird, angeordnet sein.

Soll die Kühlvorrichtung in einem Teil eines Kühl- oder Kältemittelkreislaufs angeordnet sein, in welchem ein hoher Druck zu herrscht, so können das Flachrohr und die entsprechenden Anschlussrohre entsprechend druckfest ausgebildet sein.

Ferner kann die Flachrohrinnengeometrie sowie der durchströmte Querschnitt in weiten Bereichen bedarfsgerecht ausgelegt werden, so dass eine optimale Kühlleistung möglich ist.

## Patentansprüche

1. Kühlvorrichtung, insbesondere für ein elektronisches Steuergerät, mit einem von einem kühl- oder kältemitteldurchströmbaren Bereich und einem Wärmeübergangsbereich, **dadurch gekennzeichnet, dass** die Kühlvorrichtung (2) U-förmig mit einem mittleren Bereich und zwei schenkelartigen Bereichen ausgebildet ist.

2. Kühlvorrichtung nach Anspruch 1, **dadurch gekennzeichnet, dass** ein Steuergerät (1) lösbar an der Kühlvorrichtung (2) anbringbar ist, wobei Steuergerät (1) und Kühlvorrichtung (2) getrennt voneinander ausgebildet sind.

3. Kühlvorrichtung nach Anspruch 1 oder 2, **dadurch gekennzeichnet, dass** die Kühlvorrichtung (2) ein kühl- oder kältemitteldurchströmbares Flachrohr (3) aufweist, welches den kühl- oder kältemitteldurchströmbaren Bereich bildet.

4. Kühlvorrichtung nach Anspruch 3, **dadurch gekennzeichnet, dass** das Flachrohr (3) U-förmig ausgebildet ist.

5. Kühlvorrichtung nach einem der vorhergehenden Ansprüche, **dadurch gekennzeichnet, dass** das Flachrohr (3) mindestens eine Anlagefläche (E1, E2, E3) aufweist, an welcher ein Steuergerät (1) direkt oder indirekt flächig anliegen kann.

6. Kühlvorrichtung nach einem der vorhergehenden Ansprüche, **dadurch gekennzeichnet, dass** der Wärmeübergangsbereich durch mindestens ein Wärmeübertragungselement (5) gebildet ist.

7. Kühlvorrichtung nach Anspruch 6, **dadurch gekennzeichnet, dass** das Wärmeübertragungselement (5) an zwei benachbarten Seiten des Flachrohrs (3) flächig anliegt oder einstückig mit demselben ausgebildet ist.

8. Kühlvorrichtung nach Anspruch 6 oder 7, **dadurch gekennzeichnet, dass** zwei Wärmeübertragungselemente (5) vorgesehen sind, wobei jeweils eines an einem der beiden Schenkeln des Flachrohrs (3) ausgebildet oder angeordnet ist.

9. Kühlvorrichtung nach einem der Ansprüche 6 bis 8. **dadurch gekennzeichnet, dass** das Wärmeübertragungselement (5) Z-förmig ausgebildet ist, wobei jeweils zwei benachbarte Ebenen (E1 und E2; E2 und E3) senkrecht zueinander angeordnet sind.

10. Kühlvorrichtung nach einem der Ansprüche 6 bis 9. **dadurch gekennzeichnet, dass** das Wärmeübertragungselement (5) am Flachrohr (3) angelötet ist.

11. Kühlvorrichtung nach einem der Ansprüche 6 bis 10, **dadurch gekennzeichnet, dass** das Wärmeübertragungselement (5) mindestens einen Vorsprung (7) für die Positionierung und Vorfixierung desselben am Flachrohr (3) aufweist.

12. Kühlvorrichtung nach einem der Ansprüche 6 bis 11. **dadurch gekennzeichnet, dass** das Wärmeübertragungselement (5) eine Prägung (8) für die Positionierung des Anschlussrohres aufweist.

13. Kühlvorrichtung nach einem der vorhergehenden Ansprüche, **dadurch gekennzeichnet, dass** an der Kühlvorrichtung (2) ein Teil einer Haltevorrichtung (6) für das Steuergerät (1) vorgesehen ist.

14. Steuergerät (1) mit Kühlvorrichtung (2), **gekennzeichnet durch** eine Kühlvorrichtung (2) nach einem der Ansprüche 1 bis 13, die lösbar am Steuergerät (1) angebracht ist.

15. Steuergerät (1) mit Kühlvorrichtung (2) nach Anspruch 14, **dadurch gekennzeichnet, dass** eine Haltevorrichtung (6) vorgesehen ist, wobei Teil der Haltevorrichtung (6) mindestens ein mit einem Kopf (10) versehener, vorstehender Bereich am Steuergerät (1), eine Öffnung in der Kühlvorrichtung (2), durch welche der Kopf (10) am Steuergerät (1) ragt, und mindestens ein mit einer Öffnung versehenes Federelement ist, das auf den am Steuergerät (1) ausgebildeten Kopf (10) aufgesetzt und gegen denselben verspannt ist.
